(19) Europäisches Patentamt
European Patent Office
Office européen des brevets

(11) **EP 0 918 043 B1**

(12) **EUROPÄISCHE PATENTSCHRIFT**

(45) Veröffentlichungstag und Bekanntmachung des Hinweises auf die Patenterteilung:
**14.09.2005  Patentblatt 2005/37**

(51) Int Cl.$^7$: **C03C 17/245**, C23C 14/08, C23C 14/34

(21) Anmeldenummer: **98121350.7**

(22) Anmeldetag: **10.11.1998**

(54) **Mit mindestens einer MgO-Schicht beschichtetes Substrat**

Substrate coated with at least one MgO-layer

Substrat revêtu d'au moins une couche de MgO

(84) Benannte Vertragsstaaten:
**DE FR NL**

(30) Priorität: **20.11.1997  EP 97120354**

(43) Veröffentlichungstag der Anmeldung:
**26.05.1999  Patentblatt 1999/21**

(73) Patentinhaber: **Unaxis Trading AG**
**9477 Trübbach (CH)**

(72) Erfinder:
 • **Stollenwerk, Johannes**
  **63571 Gelnhausen (DE)**
 • **Daube, Christoph**
  **63755 Alzenau (DE)**
 • **Guerke, Achim**
  **63739 Aschaffenburg (DE)**

(74) Vertreter: **Troesch Scheidegger Werner AG**
**Patentanwälte**
**Postfach**
**8032 Zürich (CH)**

(56) Entgegenhaltungen:
**EP-A- 0 570 182       EP-A- 0 803 587**

 • **PATENT ABSTRACTS OF JAPAN vol. 013, no. 562 (C-665), 13. Dezember 1989 & JP 01 234398 A (MATSUSHITA ELECTRIC IND CO LTD), 19. September 1989**
 • **YASUHISA KANEKO ET AL: "PREPARATION OF MGO THIN FILMS BY RF MAGNETRON SPUTTERING" JAPANESE JOURNAL OF APPLIED PHYSICS, Bd. 30, Nr. 5, 1. Mai 1991, Seiten 1091-1092, XP000263714**
 • **BRULEY J ET AL: "NANOSTRUCTURE AND CHEMISTRY OF A (100)MGO/(100)GAAS INTERFACE" APPLIED PHYSICS LETTERS, Bd. 65, Nr. 5, 1. August 1994, Seiten 564-566, XP000464872**
 • **TSUGUO ISHIHARA ET AL: "STRUCTURE OF MGO FILMS PREPARED BY ION BEAM SPUTTERING" JOURNAL OF THE CERAMIC SOCIETY OF JAPAN, INTERNATIONAL EDITION, Bd. 97, Nr. 8, 1. August 1989, Seiten 4-10, XP000083701**

**Beschreibung**

Die vorliegende Erfindung betrifft ein mit mindestens einer MgO-Schicht beschichtetes Substrat nach dem Oberbegriff von Anspruch 1.

Es ist bekannt, relativ grossflächige Substrate, wie insbesondere Plasma-Display-Panel-Substrate, durch Elektronenstrahlbedampfen mit einer MgO-Schicht hoher Qualität zu beschichten. Die hohe Qualität ergibt sich beispielsweise durch die, verglichen mit der Dichte ρ von MgO-Bulkmaterial von 3,58g/cm3, geforderte sehr hohe Dichte des MgO-Schichtmaterials, nämlich zwischen 85% und 95% der erwähnten Bulkmaterialdichte ρ.

Im nachfolgenden wird der Begriff "Θ-2Θ-Methode" verwendet.

- Diese Methode ist in F. Kohlrausch, Praktische Physik, Band 2, 23. Auflage, Seite 753, B.G. Teubner, Stuttgart 1985, definiert. Demnach besteht das Bragg-Verfahren in der Drehung des Kristalls um Θ, gekoppelt mit der Drehung des Detektors um 20, und wird hier als "Θ-2Θ-Methode" bezeichnet.

- Wenn von "Spitzen bei (xyz)" gesprochen wird, so ist damit der peak-Verlauf des Θ-2Θ-Methoden-Resultat-Verlaufes bzw. Diagrammes verstanden, der der (xyz)-Orientierung entspricht, wie üblicherweise in der Kristallografie verwendet.

- Wenn von einer "überragenden Spitze" gesprochen wird, so heisst dies im Θ-2Θ-Methoden-Diagramm eine Spitze, die höher ist als alle anderen.

- Wenn vom Vorhandensein einer einzigen Spitze die Rede ist, ist damit eingeschlossen das Vorhandensein von Spitzen höherer Ordnung, also z.B. einer Spitze bei (222), wenn vom Vorhandensein allein der Spitze bei (111) gesprochen wird.

Das durch Elektronenstrahlbedampfen abgelegte Schichtmaterial weist den wesentlichen Nachteil auf, dass es bei Untersuchung mit der Θ-2ΘMethode keine überragende Spitze aufweist.

Aus der EP-A-0 803 587 ist es bekannt, MgO-beschichtete Substrate herzustellen, durch reaktives Sputtern metallischer Targets oder durch ggf. zusätzlich reaktives Sputtern oxydischer Targets.

Die MgO-beschichteten Substrate eignen sich für Plasma Display Panels.

Aus der JP-01 234 398 sind MgO-beschichtete Halbleiter oder Glassubstrate bekannt, welche eine überragende Spitze bei (111) oder (100) haben.

Ausgehend von einem sich für Plasma Display Panels eignenden MgO-beschichteten Substrat, stellt sich die vorliegende Erfindung zur Aufgabe, ein derartiges Substrat vorzuschlagen, dessen MgO-Beschichtung besonders für diesen Einsatz optimierte Eigenschaften hat.

Zu diesem Zweck zeichnet sich das eingangs genannte Substrat nach dem Kennzeichen von Anspruch 1 aus.

Obwohl das erfindungsgemässe Substrat, insbesondere dank der realisierten, mittels der Θ-2Θ-Methode gemessenen, überragenden Spitze, Eigenschaften aufweist, die ein Substrat, hergestellt durch Elektronenstrahlverdampfen, nicht aufweist, sind Schichtmaterialdichten realisiert, die mindestens 80%, vorzugsweise mindestens 90%, der Dichte von stöchiometrischem MgO-Bulkmaterial betragen. An MgO-Bulkmaterial ist die Dichte ρ = 3,58g/cm3.

Bei beschichteten Plasma-Display-Panel-Substraten ist oft eine überragende Spitze bei (111) erwünscht oder gar ausschliesslich eine Spitze bei (111). Die Herstellung von derartigen Substraten mittels Elektronenstrahlverdampfens ist, wie erwähnt, nicht möglich.

Es kann auch allein - also an Stelle der überragenden Spitze bei (111) - oder zusätzlich eine Spitze bei (200) und/oder bei (220) vorhanden sein oder an anderen Stellen.

Dem Wortlaut von Anspruch 3 folgend, weist die Schicht am erfindungsgemässen Substrat, weiter bevorzugterweise, einen Brechungsindex n für Licht in einem Wellenlängenbereich von mindestens 400nm bis 800nm, vorzugsweise gar von 350nm bis 820nm, auf, für den gilt:

$$1{,}5 \le n \le 1{,}8,$$

vorzugsweise

$$1{,}59 \le n \le 1{,}75.$$

Gemäss Wortlaut von Anspruch 4 ist weiter die Oberflächenrauheit der Schicht über das Substrat homogen und liegt vorzugsweise zwischen 0,5nm RMS (Effektivwert) und 18nm RMS, insbesondere für Schichtdicken zwischen 200nm und 800nm, gemessen mittels Raster-Kraftmikroskopie.

Im weiteren ist bevorzugterweise, und wie in Anspruch 6 angegeben, am erfindungsgemässen Substrat das MgO-Material stöchiometrisch vorliegend.

Durch ein beschriebenes Herstellverfahren ist es dabei einerseits möglich, das erfindungsgemässe Substrat zu realisieren, und dies, dank dem eingesetaten, reaktiven Sputterbeschichten mit hohen Beschichtungsraten und mit hoher Targetmaterialausnützung d. h. ausserst kostengünstig. Damit sind die erwähnten grossflächigen Substrate kostengünstig bei hohen Durchsätzen industriell herstellbar.

Als Arbeitsgas wird vorzugsweise Argon eingesetzt, mindestens als Anteil des Reaktivgases Sauerstoff. Es hat sich gezeigt, dass durch Einbringen eines Reaktivgases im wesentlichen aus Sauerstoff und Wasserstoff höchst erwünschte weitere Vorteile erwirkt werden. Dabei kann der in die Prozessatmosphäre eingebrachte Wasserstoffanteil gegebenenfalls mit dem Arbeitsgas, aber insbesondere bevorzugt mit dem Reaktivgas, d.h. Sauerstoff, eingebracht werden. Gegebenenfalls werden die beiden Reaktivgase Sauerstoff und Wasserstoff vorab gemischt. Wasserstoff wird dabei mit einem Anteil zwischen 0 % (reiner Sauerstoff als Reaktivgas) und 50 %, bezogen auf die Reaktivgasmenge, eingelassen, vorzugsweise mit 0 % bis 10 %. Die durch Einsetzen von Wasserstoffgas erwirkten Vorteile sind einerseits, dass die Oberflächenrauheit der MgO-Schicht beeinflusst wird, anderseits deren Kristallstruktur:

Durch Einbringen von Wasserstoffgas in die Prozessatmosphäre wird es möglich, die Oberflächenrauheit der Schicht einzustellen. So ist es möglich, dadurch die Oberflächenrauheit beispielsweise um 50 % zu verringern, z.B. von 10 nm RMS auf 5 nm RMS, dass Wasserstoffgas in die Prozessatmosphäre eingelassen wird.

Wird beispielsweise in reiner Sauerstoff-Reaktivgasatmosphäre eine Kristallstruktur mit überragender Spitze bei (111) realisiert, so wird beispielsweise bei Einlassen von 2,5 % Wasserstoff, bezogen auf die Reaktivgasmenge, eine Kristallstruktur an der MgO-Schicht von mit überragender Spitze bei (220) erreicht, bei 5 % Wasserstoffeinlass von bei (200). Damit ist es möglich, mit der Wasserstoffbeigabe in die Prozessatmosphäre Oberflächenrauheit bzw. Kristallstruktur der MgO-Schicht einzustellen.

Die Erfindung wird anschliessend beispielsweise anhand von Figuren erläutert.

Es zeigen:

Fig. 1 perspektivisch und schematisch, ein System zur Herstellung des erfindungsgemässen Substrates;

Fig. 2 an einem erfindungsgemässen Substrat, das Θ-2Θ-Methoden-Diagramm mit überragenden Spitzen bei (111) bzw. bei (200) und bei variiertem Sauerstofffluss;

Fig. 3 in Darstellung analog zu Fig. 2, die Einstellung der Spitzen durch Variation der Substrattemperatur T beim Beschichten;

Fig. 4 in Darstellung analog zu Fig. 2, die Spitzen an einem erfindungsgemässen Substrat (b) und an polykristallinem MgO-Pulver (a) als Vergleich;

Fig. 5 an einem erfindungsgemässen Substrat, den Verlauf des Absorptionskoeffizienten in Funktion der Wellenlänge einfallenden Lichtes;

Fig. 6 an einem erfindungsgemässen Substrat gemäss Fig. 5, den Verlauf des Brechungsindex n in Funktion der Wellenlänge einfallenden Lichtes;

Fig. 7 den spektralen Verlauf der prozentualen Transmission von AF 45 Glas (a), als Vergleich, und an einem erfindungsgemässen Substrat mit dem AF 45 Glas;

Fig. 8 entlang der Ebene E von Fig. 1 betrachtet, die Verteilung auf das Substrat in stationären Zustand abgelegten Schichtmaterials in Prozent des Maximumwertes;

Fig. 9 an einem erfindungsgemässen Plasma-Display-Panel-Substrat die Verteilung der MgO-Schichtdicke;

Fig. 10 an einem bei T = 200°C beschichteten erfindungsgemässen Substrat die mittels Raster-Kraftmikroskopie aufgenommene Oberflächenrauheit.

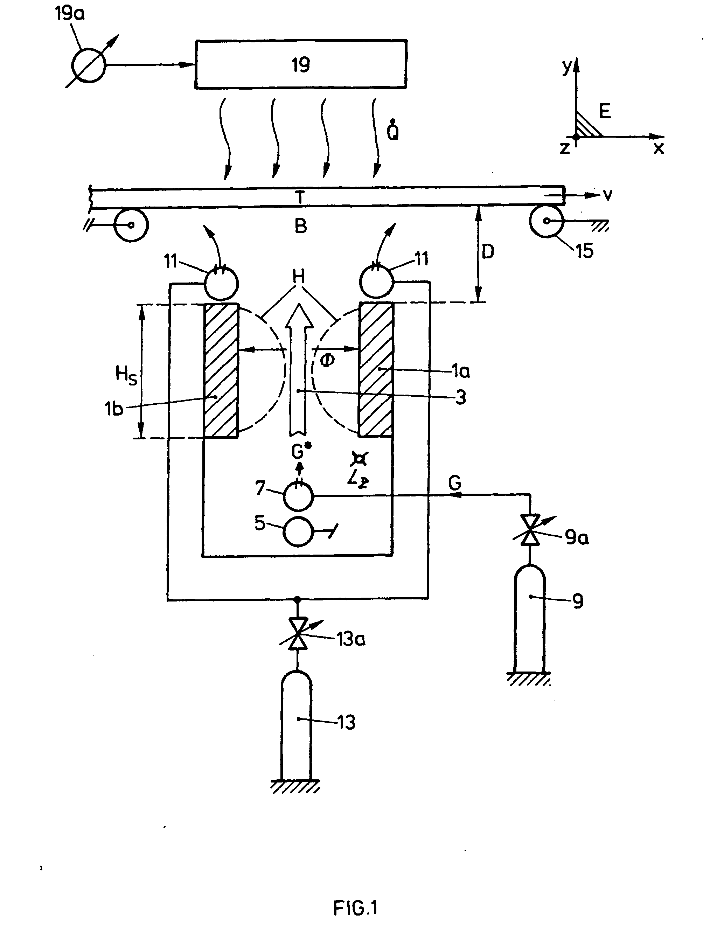

In Fig. 1 ist schematisch ein Beschichtungssystem dargestellt, welches sich für die Herstellung des erfindungsgemässen Substrates eignet. Bezüglich weiterer Systeme, welche sich mindestens ebenso gut hierfür eignen, sei vollumfänglich auf die EP-0 803 587 verwiesen bzw. auf die US-Anmeldung Nr. 08/895 451. Solche Anlagen werden "Gasfluss-Sputterquellen"-Anlagen genannt.

Wesentlich an der eingesetzten Gasfluss-Sputterquelle ist mindestens ein Targetpaar mit Targets 1a und 1b, welche zwischen sich gemäss Fig. 1 einen beidseits offenen, in Z-Richtung ausgedehnten Spalt 3 bzw., gemäss der EP-0 803 587, einen in sich geschlossenen, in Z-Richtung ausgedehnten Spalt definieren. Die Spaltausdehnung in Z-Richtung ist z.B. 1600mm. Die Targets werden bevorzugterweise (nicht dargestellt) DC-betrieben, wobei auch ein AC- bzw. ein DC-Betrieb mit überlagertem AC- bzw. ein gepulster DC-Betrieb möglich ist. Im einen Endbereich des Spaltes 3 ist eine Anodenanordnung 5 vorgesehen sowie eine sich entlang des Spaltes 3 erstreckende Gasausdüsanordnung 7, die, wie schematisch dargestellt, mit einem Arbeitsgastank 9, vorzugsweise mit Argon, über ein Stellorgan 9a verbunden ist.

An dem der Gaseindüsanordnung 7 abgewandten Spaltbereich ist eine weitere Gaseindüsanordnung 11 vorgesehen, welche, wie wiederum schematisch dargestellt, über ein Stellorgan 13a mit einer Sauerstoff enthaltenden Gastankanordnung 13 verbunden ist. Die Gaseindüsanordnung 11 ist so ausgelegt und deren Gasdüsen sind so gerichtet, dass das Gas nicht direkt zwischen die Targets, sondern in den Endbereich ausströmt, zum Zwecke der Verwirbelung. Die Gastankanordnung 13 enthält entweder mindestens im wesentlichen nur Sauerstoff oder Sauerstoff und Wasserstoff. In letzterwähntem Fall sind mittels entsprechender Stellorgane entweder Tanks für Sauerstoff und Wasserstoff vorgesehen, oder das Reaktivgasgemisch Sauerstoff/Wasserstoff ist vorgemischt in einer Tankanordnung vorgesehen. Der gegebenenfalls in der Prozessatmosphäre eingelassene Wasserstoffanteil kann wie erwähnt und bevorzugt durch die Reaktivgas-Eindüsanordnung 11 eingelassen werden und/oder mit dem Arbeitsgas über die Gaseindüsanordnung 7.

Oberhalb des mit der Sauerstoff-Eindüsanordnung 11 versehenen Spaltendes ist, wie schematisch bei 15 dargestellt, eine Träger- und Vorschubanordnung für ein planes Substrat 17 mit einer Ausdehnung von mindestens 100mm x 100mm vorgesehen, womit das Substrat 17, senkrecht zu der in Fig. 1 eingetragenen Gasflussrichtung G des Arbeitsgases durch den Spalt 3, vom Spaltende mit der Reaktivgas-Eindüsanordnung 11 beabstandet, vorzugsweise linear gleichförmig durchbewegt wird.

Auch bei der in Fig. 1 dargestellten Anordnung mit einem seitlich beidseits offenen Spalt 3 werden bevorzugterweise die in der obgenannten EP-0 803 587 definierten Betriebsparameter und geometrischen Verhältnisse realisiert:

-   <u>Totaldruck</u> im Beschichtungsraum B: 0,1 bis 10mbar;

-   <u>Partialdruck</u> Reaktivgas: bis 10% vom Totaldruck im Beschichtungsraum B;

-   <u>Reaktivgas</u>: $O_2$ oder $O_2$ und $H_2$. In letzterem Fall 0 % - 50 % $H_2$ bezüglich Reaktivgasmenge, vorzugsweise 0 % - 10 %.

-   <u>Austrittsströmung</u> des Arbeitsgases G -Ar- aus der Spaltöffnung in den Behandlungsraum B:

Die Arbeitsgas-, vorzugsweise Ar-Gasströmung G wird im knudsenschen oder viskosen Bereich realisiert. Dabei gilt:

Knudsenscher Bereich:

$$10^{-2} mbar \cdot cm \le p \cdot \Phi \le 0,6 mbar \cdot cm;$$

Viskoser Bereich:

$$0,6 mbar \cdot cm < p \cdot \Phi,$$

mit p als Totaldruck im Spalt 3 und $\Phi$ als Spaltbreite.

Vorzugsweise wird die Gasströmung im knudsenschen Bereich gewählt. Weiter gilt vorzugsweise:

$$10 sccm/cm^2 \le F \le 200 sccm/cm^2,$$

mit F als Arbeitsgasfluss pro Spaltöffnungs-Flächeneinheit, vorzugsweise

$$20 sccm/cm^2 \le F \le 50 sccm/cm^2.$$

<u>Spaltbreite</u> $\Phi$ bzw. Abstand der Targets 1a, 1b:

$$5 mm \le \Phi \le 40 mm,$$

vorzugsweise

$$\Phi \le 25 mm,$$

vorzugsweise

$$8 mm \le \Phi \le 20 mm.$$

<u>Spalttiefe</u> (Targetbreite) $H_S$ in Richtung G von Fig. 1:

$$1 cm \le H_S \le 20 cm,$$

<u>Spalthöhe</u> $L_z$: z.B. 1600mm.

Falls, magnetronähnlich, an den beiden Targets 1a, 1b ein tunnelförmiges Magnetfeld H realisiert wird, so bevorzugterweise so, dass, parallel zu den Zerstäubungsflächen der beiden Targets 1a und 1b, in der Mitte des Spaltes 3 gemessen, gilt:

$$150 \ Gauss \le H \le 1200 \ Gauss,$$

dabei vorzugsweise $H \ge 300$ Gauss,

bevorzugterweise $300 \ Gauss \le H \le 800 \ Gauss.$

Mittels einer an einer Stellanordnung 19a steuer- oder regelbaren Heiz- und/oder Kühlanordnung wird die Substrattemperatur T im Bereich B eingestellt.

Eine wie in Fig. 1 schematisch dargestellte Beschichtungsanlage wurde, unter Einhalt der vorerwähnten Dimensionierungs- und Betriebsregeln, wie folgt aufgebaut und betrieben:

-   Targetmaterial 1a, 1b: Mg3N5, Reinheit 99,95%;

-   Targetentladespannung bezüglich der auf Masse geschalteten Anode 5: 310V;

4

- Entladestrom: 27A;

- Leistungsdichte pro Targetflächeneinheit bei planen Zerstäubungsneuflächen: 15W/cm$^2$;

- Arbeitsgas: Ar;
  Fluss: 8000sccm;

- Reaktivgas: O$_2$, Fluss variabel;

- Totaldruck im Bereich B: 0,4mbar;

- Substrattemperatur: 200°C, variabel;

- Substratfläche: 300 x 400mm$^2$;

- dynamische Beschichtungsrate: 30-50nm.m/min;

- Substrat-Spaltabstand D: 50mm;

- Vorschub v: 0,7m/min

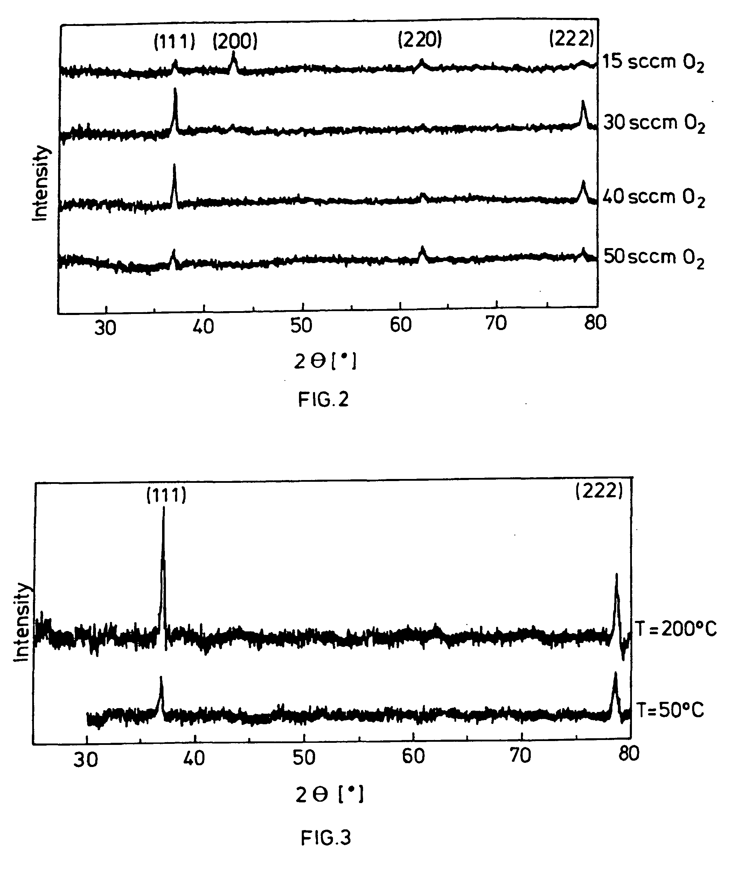

In Fig. 2 ist der Messungsverlauf der Θ-2Θ-Methode an der MgO-Schicht am beschichteten erfindungsgemässen Plasma-Display-Panel-Glassubstrat -AF 45- dargestellt. An der Anordnung gemäss Fig. 1 wurde der Sauerstofffluss, wie bei 13a dargestellt, verändert. Wie ersichtlich, können mit Einstellung dieses Flusses Lage und Höhe der auftretenden Spitzen eingestellt werden. Auf einem Plasma-Display-Panel-Substrat war vorliegendenfalls ausschliesslich eine Spitze bei (111) erwünscht, was mit einem Sauerstofffluss von 30sccm bzw. 40sccm erreicht wurde. Bei (222) erscheint das Signal zweiter Ordnung.

Es ist ersichtlich, dass durch Einstellung des Sauerstoff-Gasflusses die Lage und Ausprägung der auftretenden Spitzen gewählt werden kann, wobei auch andere Lagen, wie z.B. bei (200) und/oder (220), eingestellt werden können.

In Fig. 3 ist dargestellt, dass am Herstellverfahren, gemäss Fig. 1, bzw. generell mittels der Gasfluss-Sputterquelle, auch mit der Substrattemperatur T während des Beschichtungsvorganges die Spitzen eingestellt werden können. Bevorzugterweise werden beide Parameter, nämlich Sauerstofffluss gemäss Fig. 2 und Substrattemperatur T, zur Einstellung der Lage und Ausprägung der Spitzen eingesetzt.

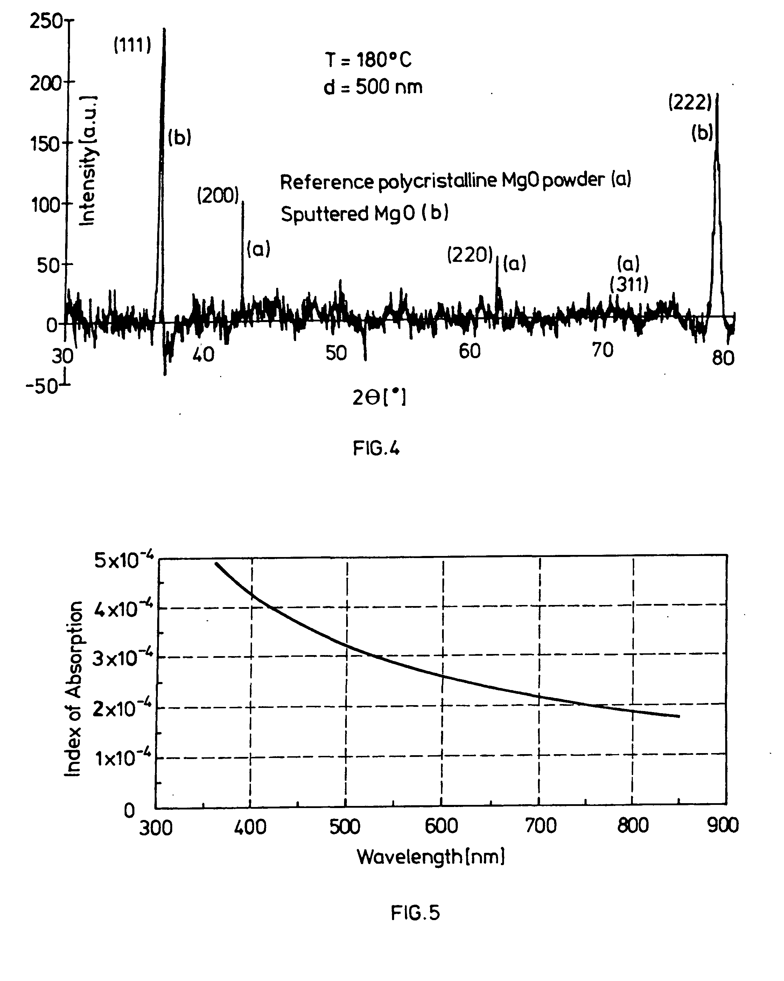

In Fig. 4 ist der Messverlauf (b) der Θ-2Θ-Methode dargestellt, aufgenommen an einem erfindungsgemässen Substrat mit einer 500nm dicken MgO-Schicht, abgelegt bei einer Temperatur T = 180°C. Die Spitzen (a) bei (200), (220) und (311) sind Spitzen an polykristallinem MgO-Pulver, als Vergleich.

In Fig. 5 ist der Verlauf des Absorptionskoeffizienten in Funktion der Wellenlänge einfallenden Lichtes an dem wie erwähnt hergestellten erfindungsgemässen Substrat bzw. der darauf aufgebrachten MgO-Schicht dargestellt.

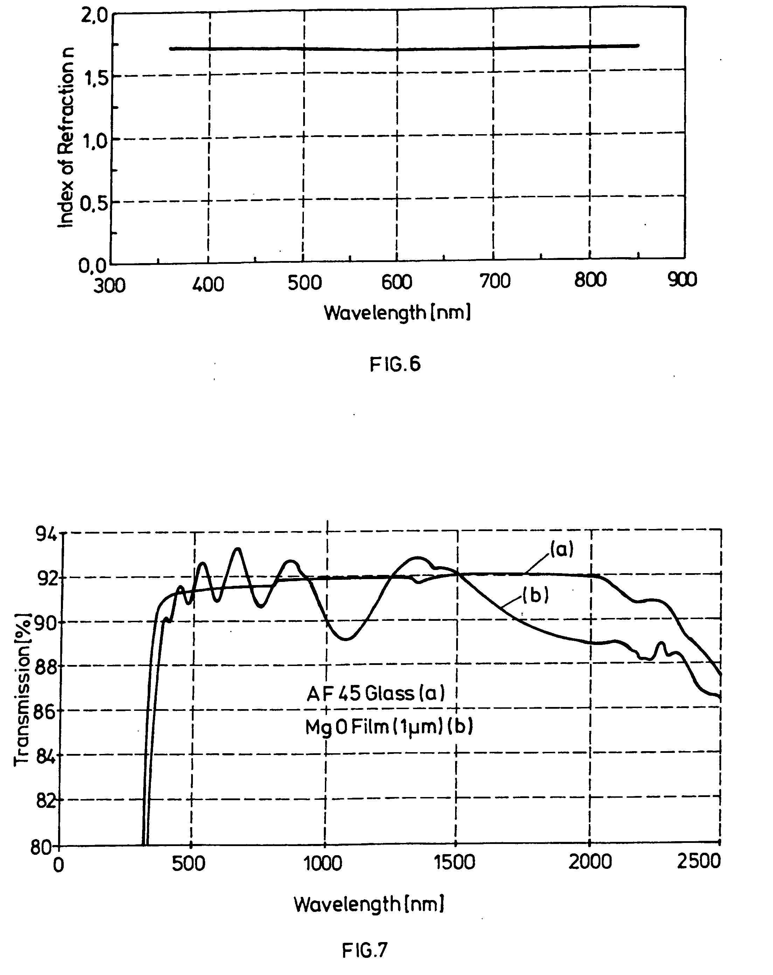

Bei dem wie erwähnt wesentlich unwirtschaftlicheren Elektronenstrahlbedampfen von Substraten mit hochqualitativen MgO-Schichten werden Brechungsindizes nahe beim erwünschten Wert von 1,7 erzielt. Wie sich aus Fig. 6 an einem erfindungsgemässen Substrat ergibt, ergeben sich auch hier Brechungsindexwerte zwischen 1,5 und 1,8, vorzugsweise zwischen 1,59 und 1,75. Dies bevorzugt über einen Wellenlängenbereich von mindestens 400nm bis 800nm, gemäss Fig. 6 gar zwischen 350nm und 820nm.

In Fig. 7 ist die prozentuale Transmission von unbeschichtetem AF 45 Glas (a) und (b) an einem erfindungsgemässen Substrat mit dem AF 45 Glas und beschichtet mit einer 1μm dicken MgO-Schicht dargestellt.

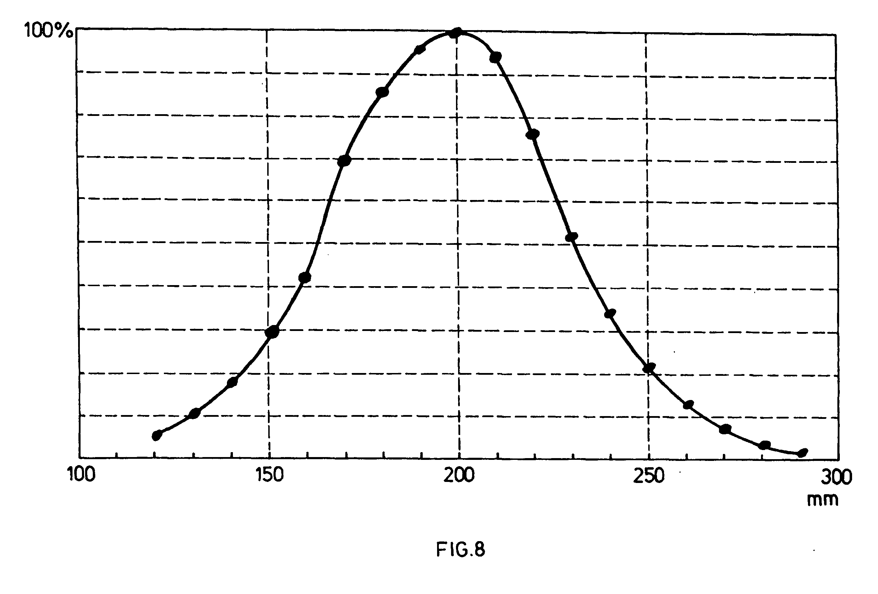

In Fig. 8 ist, rückschauend auf die Beschichtungsanordnung gemäss Fig. 1, die Beschichtungsratenverteilung in der in Fig. 1 eingetragenen Ebene E dargestellt, bei stationär gehaltenem Substrat. Wie erwähnt, beträgt der Substrat-zu-Spalt-Abstand D 50mm.

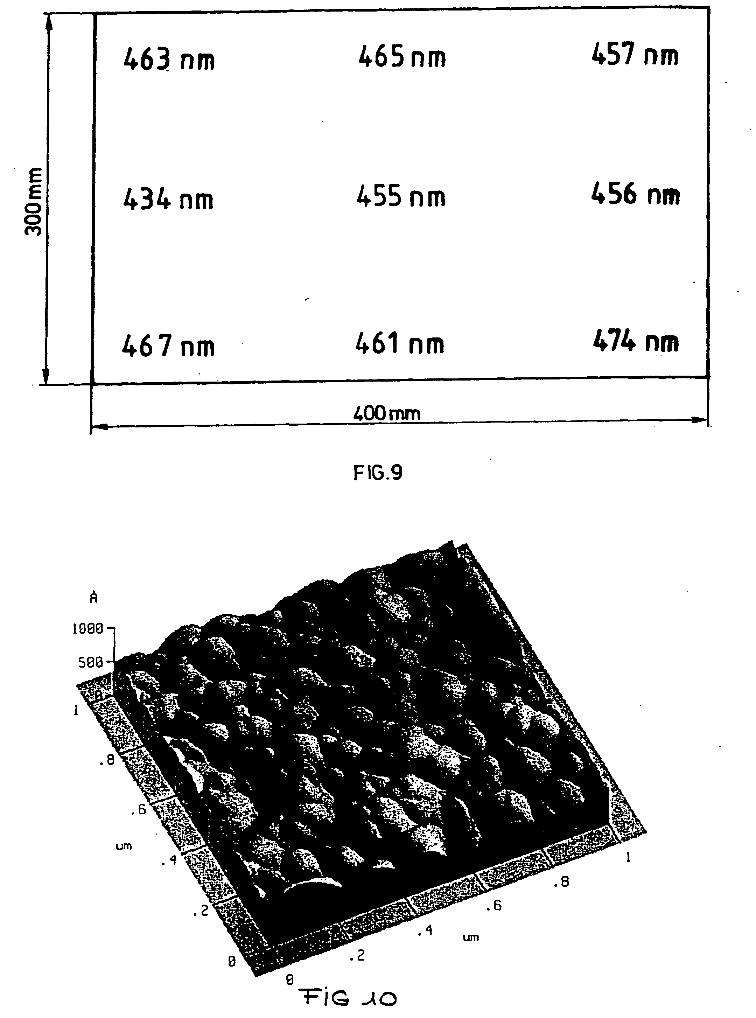

In Fig. 9 ist an einem erfindungsgemässen Plasma-Display-Panel-Substrat mit der Ausdehnung 300mm x 400mm die Schichtdickenverteilung angegeben. Daraus ist ersichtlich, dass die Schichtdickenverteilung trotz der Grösse des Substrates wesentlich besser ist als ± 10% bezüglich des Schichtdicken-Mittelwertes.

In Fig. 10 ist schliesslich die mittels Raster-Kraftmikroskopie aufgenommene Oberflächenrauheit an einer bei 200°C an einem erfindungsgemässen Substrat abgelegten MgO-Schicht mit der Dicke 500nm.

An dem erfindungsgemässen Substrat, insbesondere realisiert nach dem beschriebenen Verfahren, kann die Oberflächenrauheit insbesondere durch Wahl der Beschichtungstemperatur in einem grossen Bereich gewählt werden, nämlich zwischen 0,5nm RMS und 18nm RMS, insbesondere für Schichtdicken zwischen 200nm und 800nm und gemessen mittels Raster-Kraftmikroskopie.

Mit dem erfindungsgemässen Substrat, insbesondere dem erfindungsgemässen Plasma-Display-Panel-Substrat, wird, industriell kostengünstig fertigbar, gezielt eine überragende Spitze insbesondere bei (111) vorgeschlagen, an einer MgO-Schicht mit hoher Dichte. Beim Herstellungsverfahren sind sehr hohe dynamische Beschichtungsraten von weit über 30nm.m/min erzielbar, was mit zur erwähnten Produktivität beiträgt, nebst der Tatsache, dass das Targetmaterial zu über 70% ausnützbar ist.

Es ist darauf hinzuweisen, dass beim Elektronenstrahlverdampfen das Verdampfungsmaterial in der Grössenordnung von 10% ausgenützt werden kann. Obwohl im heutigen Zeitpunkt noch nicht erprobt, ist zu vermuten, dass durch Einsatz von Gasfluss-Sputterquellen gemäss der EP-0 803 587 noch weit höhere Beschichtungsraten erzielbar sind, insbesondere unter Einsatz magnetronähnlicher Magnetfelder.

Im weiteren wurde mittels Electron Probe Micro Analysis (EPMA) festgestellt, dass die abgelegten MgO-Schichten keine Arbeitsgas-, insbesondere Ar-Einschlüsse aufweisen. Auf Grund der Einstellbarkeit der Oberflächenrauheit und der realisierten überragenden Spitzen ist es möglich, für ein erfindungsgemässes Plasma-Display-Panel-Substrat die Oberfläche pro beschichtete Substratflächeneinheit zu optimieren, was zum Erzielen hoher Sekundärelektronen-Emissionskoeffizienten wünschbar ist. Dabei scheint eine überragende Spitze bei (111) optimal zu sein. Dabei ergibt sich, wie der Quervergleich von Fig. 3 (T = 200°C) und 10 zeigt, bei der Spitze bei (111) auch eine hohe Oberflächenrauheit im Bereich von 0,5nm RMS. Wie erwähnt, kann auch anstelle von reinem Sauerstoff als Reaktivgas in der Prozessatmosphäre vorzugsweise bis zu 50 %, insbesondere bevorzugt bis zu 10 %, der Reaktivgasmenge als Wasserstoffgas eingelassen werden. Durch diesen Wasserstoffgaszusatz ist es möglich, mit sonst unveränderten Prozessbedingungen, die resultierende Oberflächenrauheit der MgO-Schicht einzustellen bzw. die Kristallstruktur der MgO-Schicht im Sinne der überragenden Spitzen. Wird, wie erwähnt bei sonst gleichen, unveränderten Prozessbedingungen, Wasserstoffgas als Reaktivgasanteil eingelassen, so ist es möglich, die Oberflächenrauheit beispielsweise um 50 %, so von z.B. 10nm RMS auf 5nm RMS, zu senken.

Im weiteren ist es durch diese Wasserstoffgas-Beimessung möglich, die Kristallstruktur im Sinne der erwähnten überragenden Spitzen an der MgO-Schicht einzustellen. Wird bei einem gegebenen Prozess mit Sauerstoff eine überragende Spitze bei (111) realisiert, so wird beispielsweise bei Zufügen von 2,5 % Wasserstoff, bezogen auf die Reaktivgasmenge, eine Spitze bei (220), bei 5 % Wasserstoffeinlass bei (200) realisiert. Damit ist es möglich, gezielt mit Wasserstoffbeimischung in die Reaktivgasatmosphäre Oberflächenrauheit bzw. Kristallstruktur der MgO-Schicht einzustellen.

## Patentansprüche

1. Mit mindestens einer MgO-Schicht beschichtetes Substrat, **dadurch gekennzeichnet, dass** das beschichtete Substrat eine Ausdehnung von mindestens 100 mm x 100 mm hat, die Dichte des Schichtmaterials mindestens 80 % von stöchiometrischem MgO-Bulkmaterial ist, die $p = 3,58 g/cm^3$ beträgt und die Schicht mindestens eine überragende Spitze im Messverlauf der 0-20-Methode aufweist.

2. Substrat nach Anspruch 1, **dadurch gekennzeichnet, dass** die Schicht eine Spitze bei (200) und/oder bei (220) und/oder bei (111) aufweist, dass vorzugsweise eine Spitze bei (111) vorhanden und die überragende ist und weiter vorzugsweise als einzige vorhanden ist.

3. Substrat nach einem der Ansprüche 1 bis 2, **dadurch gekennzeichnet, dass** die Schicht einen Brechungsindex n für Licht in einem Wellenlängenbereich von mindestens 400nm bis 800nm, vorzugsweise von mindestens 350nm bis 820nm aufweist, für den gilt:

$$1,5 \leq n \leq 1,8,$$

vorzugsweise

$$1,59 \leq n \leq 1,75.$$

4. Substrat nach einem der Ansprüche 1 bis 3, **dadurch gekennzeichnet, dass** die Oberflächenrauheit der Schicht homogen verteilt zwischen 0,5nm RMS und 18nm RMS für Schichtdicken zwischen 200nm und 800 nm liegt, gemessen mittels Raster-Kraftmikroskopie.

5. Substrat nach einem der Ansprüche 1 bis 4, **durch gekennzeichnet, dass** die Dichte des Schichtmaterials mindestens 90% von stöchiometrischem MgO Bulkmaterial ist.

6. Substrat nach einem der Ansprüche 1 bis 5, **dadurch gekennzeichnet, dass** das Schichtmaterial stöchiometrisches MgO umfasst, vorzugsweise das MgO stöchiometrisch ist.

7. Substrat nach einem der Ansprüche 1 bis 6, **dadurch gekennzeichnet, dass** das Substrat ein Plasma-Display-Panel-Substrat ist, wie z.B. ein Glassubstrat.

8. Substrat nach einem der Ansprüche 1 bis 7, **dadurch gekennzeichnet, dass** die Schicht durch reaktives Sputtern, mittels einer GasflussSputterquelle hergestellt ist.

## Claims

1. Substrate coated with at least one MgO layer, **characterized in that** the coated substrate has an extension of at least 100 mm x 100 mm, the density of the layer material is at least 80 % of stoichiometrical MgO bulk material, which equals $p = 3.58$ g/$cm^3$ and the layer has at least one outstanding peak in the measurement trace of the Θ-2Θ- method.

2. Substrate according to claim 1, **characterized in that** the layer has a peak at (200) and/or at (220) and/or at (111), that preferably a peak at (111) exists and is the outstanding one and further preferably exists as the only one.

3. Substrate according to one of claims 1 to 2, **characterized in that** the layer has a refraction index n for light within a wavelength range from at least 400nm to 800nm preferably from at least 350nm to 820nm for which:

$$1.5 \leq n \leq 1.8,$$

preferably

$$1.59 \leq n \leq 1.75.$$

4. Substrate according to one of claims 1 to 3, **characterized in that** the surface roughness of the layer lies homogeneously distributed between 0.5nm RMS and 18nm RMS for layer thicknesses between 200nm and 800nm, measured by means of scanning force microscopy.

5. Substrate according to one of claims 1 to 4, **characterized in that** the density of the layer material is at least 90% of stoichiometrical MgO bulk material.

6. Substrate according to one of claims 1 to 5, **characterized in that** the layer material comprises stoichiometrical MgO bulk material, the MgO preferably being stoichiometrical.

7. Substrate according to one of claims 1 to 6, **characterized in** the substrate is a plasma display panel substrate, like e.g. a glass substrate.

8. Substrate according to one of claims 1 to 7, **characterized in that** the layer is manufactured by reactive sputtering by means of a gas flow sputter source.

## Revendications

1. Substrat revêtu d'au moins une couche de MgO, **caractérisé en ce que** le substrat revêtu présente une étendue d'au moins 100 mm x 100 mm, la densité du matériel de la couche est au moins 80% de celle d'un matériel Mg0 stoechiométrique en vrac, la valeur de p = 3,58 g/cm$^3$ et la couche présente au moins une pointe élevée dominante dans la courbe de la mesure selon la méthode $\theta$ - 2 $\theta$.

2. Substrat selon la revendication 1, **caractérisé en ce que** la couche présente une pointe à (200) et / on à (220) et / on à (111) et **en ce qu'**il y a de préférence une pointe à (111) qui est la pointe dominante et qui en plus est la seule pointe présenté,

3. Substrat selon l'une des revendications 1 à 2, **caractérisé en ce que** la couche présente un indice de réfraction n pour de la lumière dans une gamme de longueur d'onde d'au moins 400 nm à 800 nm, de préférence d'au moins 350 nm à 820 nm, et qui répond à la formule

$$1.5 \leq n \leq 1.8,$$

de préférence

$$1, 59 \leq n \leq 1,75$$

4. Substrat selon l'une des revendications 1 à 3, **caractérise en ce que** la rugosité de la surface de la couche est répartie de façon homogène entre 0,5 nm RMS et 18 nm RMS pour des épaisseurs de la couche entre 200 nm et 800 nm, mesurée à l'aide de la microscopie à balayage.

5. Substrat selon l'une des revendications 1 à 4, **caractérisé en ce que** la densité du matériel de la couche est au moins égale à 90 % de celle d'un matériel Mg0 stoechiométrique en vrac.

6. Substrat selon l'une des revendications 1 à 5, **caractérisé en ce que** le matériel de la couche comprend du matériel Mg0 stoechiométrique, le MgO étant de préférence stoechiométrique.

7. Substrat selon l'une des revendications 1 à 6, **caractérisé en ce que** le substrat est un substrat du type plasma-display-panel, comme par exemple un substrat en verre,

8. Substrat selon l'une des revendications 1 à 7, **caractérisé en ce que** ladite couche est fabriquée par crépitement réactif à l'aide d'une source de crépitement à flux de gaz.

FIG.1

FIG. 2

FIG. 3

FIG.4

FIG.5

FIG.6

AF 45 Glass (a)

Mg O Film (1μm) (b)

FIG.7

FIG.8

EP 0 918 043 B1

FIG.9

FIG 10